(19) Europäisches Patentamt
European Patent Office
Office européen des brevets

(11) Veröffentlichungsnummer: **0 243 964 B1**

(12) **EUROPÄISCHE PATENTSCHRIFT**

(45) Veröffentlichungstag der Patentschrift: **02.01.92**

(51) Int. Cl.$^5$: **G03F 7/023**

(21) Anmeldenummer: **87106282.4**

(22) Anmeldetag: **30.04.87**

# (54) Positiv-arbeitendes lichtempfindliches Gemisch und daraus hergestelltes lichtempfindliches Aufzeichnungsmaterial.

(30) Priorität: **02.05.86 US 858631**

(43) Veröffentlichungstag der Anmeldung:
**04.11.87 Patentblatt 87/45**

(45) Bekanntmachung des Hinweises auf die Patenterteilung:
**02.01.92 Patentblatt 92/01**

(84) Benannte Vertragsstaaten:
**DE FR GB IT NL**

(56) Entgegenhaltungen:
**EP-A- 0 150 315**
**FR-A- 2 211 677**

**PATENT ABSTRACTS OF JAPAN, Band 9, Nr. 296 (P-407)[2019], 22. November 1985; & JP-A-60 133 446 (FUJI SHASHIN FILM K.K.) 16-07-1985**

**PATENT ABSTRACTS OF JAPAN, Band 9, Nr. 308 (P-410)[2031], 4. Dezember 1985; & JP-A-60 138 544 (FUJI SHASHIN FILM K.K.) 23-07-1985**

(73) Patentinhaber: **HOECHST CELANESE CORPORATION**
**Route 202-206 North**
**Somerville, N.J. 08876(US)**

(72) Erfinder: **Potvin, Robert E.**
**100 Pawtuxet Terrace Apt.6**
**West Warwick Rhode Island 02893(US)**
Erfinder: **Alban, Jonas O. St.**
**P.O. Box 43**
**Coventry Rhode Island 02816(US)**
Erfinder: **Sobodacha, Chester J.**
**R.R. 7, Box 2857 18 Daniel Drive**
**Coventry Rhode Island 02816(US)**

(74) Vertreter: **Meyer-Dulheuer, Karl-Hermann, Dr. et al**
**HOECHST Aktiengesellschaft Werk Kalle-Albert Zentrale Patentabteilung KA Rheingaustrasse 190 Postfach 3540**
**W-6200 Wiesbaden 1(DE)**

**EP 0 243 964 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services

## Beschreibung

Die vorliegende Erfindung betrifft ein positiv-arbeitendes lichtempfindliches Gemisch, insbesondere ein Photoresistgemisch, im wesentlichen bestehend aus einem Bindemittel und einer lichtempfindlichen Verbindung.

Die Herstellung von positiv-arbeitenden Photoresistgemischen ist bekannt (US-A-3,666,473, US-A-4,ll5,l28, US-A-4,l73,470 und US-A-4,550,069). Dabei handelt es sich im wesentlichen um Kombinationen eines alkalilöslichen Novolakharzes bzw. eines Polyvinylphenols mit einer lichtempfindlichen Verbindung, gewöhnlich einer substituierten o-Chinondiazidverbindung. Die Harze und lichtempfindlichen Substanzen sind in einem organischen Lösemittel oder Lösemittelgemisch gelöst und werden als dünne Schicht bzw. Beschichtung auf einen geeigneten Schichtträger aufgebracht.

Die Novolak- bzw. Polyvinylphenolkomponenten dieser Photoresistgemische sind zwar in wäßrig-alkalischen Lösungen löslich, die lichtempfindlichen o-Chinondiazidverbindungen wirken allerdings als Auflösungsverzögerer auf das Harz. Wenn jedoch bestimmte Bereiche des beschichteten Trägers mit aktinischer Strahlung belichtet werden, erfährt die lichtempfindliche Verbindung eine durch die Bestrahlung induzierte strukturelle Umwandlung, und die belichteten Bereiche der Beschichtung werden löslicher als die unbelichteten. Aufgrund dieses Löslichkeitsunterschiedes lösen sich die belichteten Bereiche der Photoresistschicht in einer alkalischen Entwicklerlösung, so daß auf dem Träger ein positives Reliefbild entsteht.

In den meisten Fällen wird der belichtete und entwickelte Träger mit einer Ätzlösung behandelt, wobei die Photoresistschicht die nicht belichteten Bereiche des Trägers vor dem Ätzmittel schützt.

Das nach dem oben beschriebenen Verfahren auf dem Träger erzeugte Reliefbild eignet sich für verschiedene Anwendungszwecke, zum Beispiel als Maske oder Bild, beispielsweise bei der Herstellung von Halbleiterbauelementen in der Mikroelektronik.

Wichtige Eigenschaften für die kommerzielle Nutzung eines Photoresists sind die folgenden: Lichtempfindlichkeit, Entwicklungskontrast, Bildauflösung und Haftung des Resists auf dem Träger.

Hohe Lichtempfindlichkeit ist für einen Photoresist insbesondere dann wichtig, wenn er für Anwendungen eingesetzt wird, bei denen mehrere Belichtungen erforderlich sind, z.B. bei der Erzeugung von Mehrfachbildern in einem Wiederholungsverfahren oder in Fällen, in denen Licht mit abgeschwächter Intensität verwendet wird, z.B. in der Projektionsbelichtungstechnik, bei der das Licht eine Reihe von Objektiven und monochromatischen Filtern durchläuft.

Unter Entwicklungskontrast ist der Unterschied zwischen dem Prozentanteil des Schichtverlusts in den belichteten Bereichen nach dem Entwickeln und dem Prozentanteil des Schichtverlusts in den unbelichteten Bereichen (Dunkelabtrag) zu verstehen. Normalerweise wird ein resistbeschichteter Träger nach dem Belichten so lange entwickelt, bis die Schicht sich in den belichteten Bereichen im wesentlichen vollständig abgelöst hat. Der Entwicklungskontrast kann daher dadurch bestimmt werden, daß nach dem vollständigen Ablösen der belichteten Schichtbereiche der Prozentanteil des Schichtverlusts in den unbelichteten Bereichen gemessen wird.

Unter Auflösung des Resists versteht man die Fähigkeit eines Resistsystems zur Wiedergabe der kleinsten, im gleichen Abstand voneinander angeordneten Linienpaare und der zugehörigen Zwischenräume einer für die Belichtung verwendeten Maske, mit einem hohen Grad an Flankensteilheit des Bildes in den entwickelten belichteten Zwischenräumen.

Für viele technische Anwendungen, insbesondere für die Herstellung von Halbleiterbauelementen in der Mikroelektronik, muß ein Photoresist einen hohen Auflösungsgrad aufweisen, wenn er sehr kleine Linien-und Zwischenraumbreiten (in der Größenordnung von l $\mu$m) wiedergeben soll.

Die Fähigkeit eines Resists zur Wiedergabe sehr kleiner Abmessungen in der Größenordnung von l $\mu$m und darunter ist bei der Herstellung von LSI-Schaltungen (Large-Scale-Integrated) auf Siliziumchips und ähnlichen Bauteilen von größter Bedeutung. Die Schaltungsdichte auf einem solchen Chip kann bei Einsatz photolithographischer Verfahren nur durch eine Steigerung des Auflösungsvermögens des Resists erhöht werden.

Zur Erzielung der erforderlichen Lichtempfindlichkeit und des gewünschten Kontrastes muß die Konzentration an lichtempfindlichen Verbindungen in dem Photoresistgemisch hoch genug sein, um ein Lösen der unbelichteten Resistbereiche während der Entwicklung zu verhindern. Hohe Konzentrationen an lichtempfindlichen Verbindungen können entweder dadurch erreicht werden, daß man in der Photoresistlösung ein Gemisch aus hochlöslichen und weniger gut löslichen lichtempfindlichen Verbindungen löst oder daß man die Photoresistlösung mit einer lichtempfindlichen Verbindung übersättigt.

Konzentrationen an lichtempfindlicher Verbindung in der Photoresistlösung, die nahe der Sättigungsgrenze liegen, können jedoch die Lagerfähigkeit der Photoresistlösung bedeutend herabsetzen, da die Lösung in diesem Fall zu Instabilität neigt oder ein Ausfallen der lichtempfindlichen Verbindung vor oder bei

der Verwendung des Photoresistgemischs möglich ist. Auf dieses Problem wird in US-A-4,397,937 und US-A-4,526,856 hingewiesen.

Die Kondensationsprodukte aus l,2-Naphthochinondiazid-4-sulfonsäure und aromatischen Diolen oder Polyolen stellen eine bedeutende Gruppe von lichtempfindlichen Verbindungen dar. Photoresistgemische, die diese Verbindungen enthalten, zeichnen sich bei Belichtung im mittleren UV-Bereich im allgemeinen durch gute Lichtempfindlichkeit und hervorragenden Kontrast aus. Aber auch hier besteht die Neigung zu geringer Löslichkeit und zu Lösungsinstabilität.

In US-A-4,397,937 wird zur Verbesserung der Löslichkeit vorgeschlagen, als lichtempfindliche Verbindung einen Bisester aus einer l-Oxo-2-diazonaphthalinsulfonsäure und einem unsymmetrischen primären oder sekundären aliphatischen Diol, das ein Gemisch aus geometrischen Isomeren und Diastereoisomeren ist, einzusetzen. Als 1,2-Naphthochinondiazidsulfonsäuren können sowohl die -4-sulfonsäuren, die -5-sulfonsäuren als auch Mischungen der beiden eingesetzt werden, bei denen eine Hydroxylgruppe des unsymmetrischen aliphatischen Diols mit einer 1,2-Naphthochinon-5-sulfonsäure verestert, während die andere Hydroxylgruppe mit einer 1,2-Naphthochinondiazid-4-sulfonsäure verestert wird. Es kommen allerdings nur bestimmte unsymmetrische aliphatische Diole in Betracht.

In US-A-4,526,856 wird versucht, die Probleme, die bei der Erhöhung der Konzentration der lichtempfindlichen Verbindungen auftreten, durch eine Veränderung des Lösemittelsystems der Photoresistgemische zu umgehen. In bestimmten, genau einzuhaltenden Mischungsverhältnissen führt die Verwendung eines Lösemittelgemisches aus Cyclopentanon, bzw. Cyclopentanon und Cyclohexanon, und einem aliphatischen Alkohol zu gutem Lösungsverhalten.

Es war die Aufgabe der vorliegenden Erfindung, ein lichtempfindliches Gemisch vorzuschlagen, welches auch bei höheren Konzentrationen der lichtempfindlichen Verbindung ausgezeichnete Lösungseigenschaften und eine verbesserte Lagerstabilität aufweist, ohne bezüglich der erzielbaren Lichtempfindlichkeit Nachteile zu zeigen. Das lichtempfindliche Gemisch zeigt weiterhin einen höheren Kontrast und eine längere Induktionszeit, sofern es mit einem metallionenfreien Entwickler behandelt wird.

Erfindungsgemäß wird ein lichtempfindliches Gemisch vorgeschlagen, enthaltend ein in wäßrigen Systemen unlösliches, in wäßrig-alkalischen und organischen Lösemitteln lösliches, zumindest aber quellbares Bindemittel sowie eine lichtempfindliche Verbindung, dadurch gekennzeichnet, daß die lichtempfindliche Verbindung ein Kondensationsprodukt ist aus einer Phenolverbindung

der Formel I

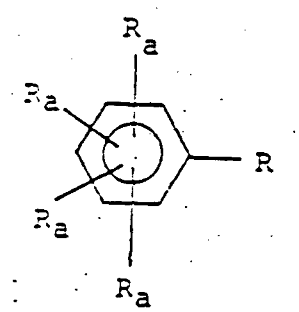

(I)

in der

R Wasserstoff, $-X-R_b$ oder

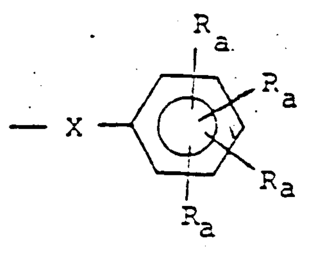

darstellt,

$R_a$ Wasserstoff, eine OH-Gruppe, Halogen oder eine niedere Alkylgruppe darstellt, wobei mindestens

zwei und höchstens sechs $R_a$-Gruppen OH-Gruppen sind,

X eine C-C-Bindung, -O-, -S-

$$-SO_2-,\ -\overset{O}{\overset{\|}{C}}-,\ -\overset{O}{\overset{\|}{C}}-(CH_2)_n-,\ -CH_2-\overset{O}{\overset{\|}{C}}-(CH_2)_n-,\ -\overset{O}{\overset{\|}{C}}-O-,\ -\overset{O}{\overset{\|}{C}}-O-(CH_2)_n-,$$

$$-CH_2-\overset{O}{\overset{\|}{C}}-O-(CH_2)_n-,\ -(CH_2)_n-\ \text{oder}\ CH_3-\underset{|}{\overset{|}{C}}-CH_3\ \text{darstellt,}$$

n 1 oder 2 bedeutet und

$R_b$ Wasserstoff oder eine gegebenenfalls substituierte Alkyl- oder Arylgruppe bedeutet;

oder der Formel II

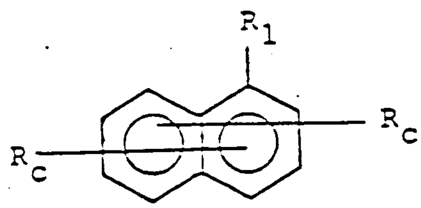

(II)

in der

$R_1$ Wasserstoff oder

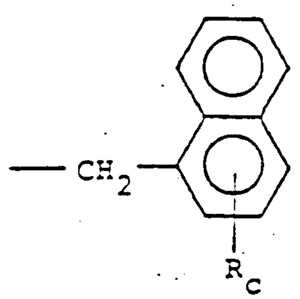

bedeutet und

$R_c$ Wasserstoff, oder eine OH-Gruppe bedeutet, wobei mindestens zwei $R_c$-Gruppen OH-Gruppen sind;

oder der Formel III

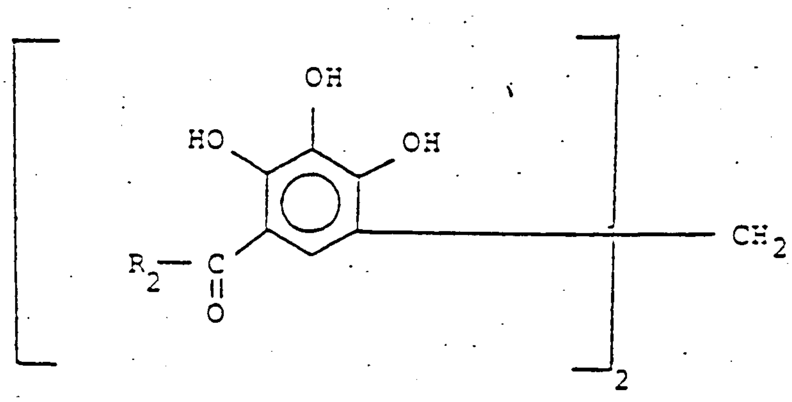 III

in der

$R_2$ Wasserstoff oder eine gegebenenfalls substituierte Alkyl- oder Arylgruppe bedeutet;

mit einer Mischung aus einem I,2-Naphthochinondiazid-5-sulfonsäurechlorid (Diazoverbindung) und einem organischen Säurehalogenid der Formel IV

$W-R_3$ (IV)

in der

W

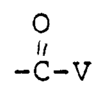

oder $-SO_2-V$ bedeutet, wobei V ein Halogen darstellt, und

$R_3$ eine gegebenenfalls substituierte Alkyl-oder Arylgruppe bedeutet.

Erfindungsgemäß wird außerdem ein Verfahren zur Herstellung eines Aufzeichnungsmaterials vorgeschlagen, bei dem ein geeigneter Träger mit einem Photoresistgemisch im wesentlichen bestehend aus einem Bindemittel und einer lichtempfindlichen Verbindung der vorstehend beschriebenen Art beschichtet wird, der beschichtete Träger mittels UV-Strahlung bildmäßig belichtet wird, und schließlich die belichteten Schichtteile mit einem wäßrig-alkalischen Entwickler vom Träger entfernt werden.

Erfindungsgemäß wird dem Ausfallen der lichtempfindlichen Verbindungen und der damit verbundenen Instabilität und geringen Lagerfähigkeit von Photoresistlösungen dadurch entgegengewirkt, daß ein Mischester aus Phenolverbindungen mit I,2-Naphthochinondiazid-5-sulfonsäure und einer nicht lichtempfindlichen organischen Säure eingesetzt werden. Beim Einsatz dieser Mischester aus Diazoverbindung und organischer Säure mit einem alkalilöslichen Bindemittel erhöht sich die Haltbarkeit und Lagerfähigkeit der Gemische, wobei im Vergleich mit anderen lichtempfindlichen Gemischen, die lediglich Ester der Diazoverbindung enthalten, die Lichtempfindlichkeit und der Entwicklungskontrast nicht reduziert sind.

Außerdem weisen die erfindungsgemäßen Photoresists einen höheren Entwicklungskontrast als bekannte Systeme auf und zeigen beim Entwickeln mit einer metallionenfreien Entwicklerlösung längere "Induktionszeiten".

Die erfindungsgemäßen lichtempfindlichen Verbindungen werden durch Kondensation von Phenolverbindungen mit einem Gemisch aus der Diazoverbindung und einem organischem Säurehalogenid erhalten. Das Molverhältnis von Diazoverbindung zu organischem Säurehalogenid in dem Gemisch liegt zwischen I:2 und 19:I, bevorzugt zwischen 2:3 und I9:I, insbesondere zwischen 7:8 und 9:1. Beispielsweise wird I Mol 2,3,4-Trihydroxybenzophenon mit einem Gemisch aus 1,4 Mol Diazoverbindung und 1,6 Mol Methansulfonsäurechlorid kondensiert. Die erhaltene lichtempfindliche Verbindung umfaßt Einheiten der allgemeinen Formel

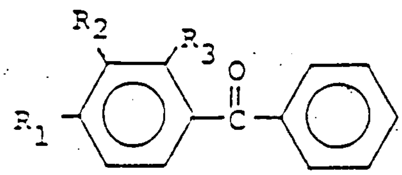

in der $R_1$, $R_2$ und $R_3$ unabhängig voneinander jeweils eine l,2-Naphthochinondiazid-5-sulfonyloxygruppe (Diazoverbindung) oder eine Methansulfonyloxygruppe bedeuten können.

Erfindungsgemäß werden lichtempfindliche Verbindungen vorgeschlagen, die durch Kondensation der Phenolverbindungen mit Gemischen aus Diazoverbindung und organischen Säurehalogeniden erhalten werden. Die Diazokomponente und die Säurehalogenidkomponente des Gemischs können gleichzeitig oder nacheinander mit der Phenolverbindung kondensiert werden.

Die Umsetzung des Gemisches aus Diazoverbindung und organischem Säurehalogenid mit den Phenolverbindungen erfolgt vorzugsweise in stöchiometrischen Verhältnissen. Doch müssen die Phenolverbindungen nicht vollständig verestert sein; es können auch kleinere als stöchiometrische Mengen an Diazoverbindung und organischem Säurehalogenid mit den Phenolverbindungen umgesetzt werden.

Die Gesamtmenge der mit den Phenolverbindungen umgesetzten Mischung aus Diazoverbindung und organischem Säurehalogenid sollte so bemessen sein, daß eine lichtempfindliche Verbindung erhalten wird, die eine ausreichende Löslichkeit des lichtempfindlichen Gemisches in alkalischem Medium nach dem Belichten gewährleistet.

Die Phenolverbindungen, die für die Kondensation mit dem Gemisch aus Diazoverbindung und organischem Säurehalogenid geeignet sind, entsprechen den nachstehend beschriebenen allgemeinen Formeln I), II), oder III):

I)

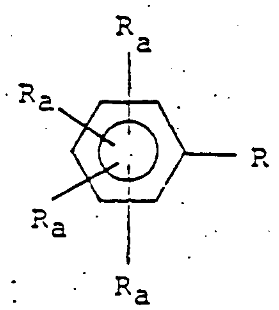

(I)

in der

R Wasserstoff, $-X-R_b$ oder

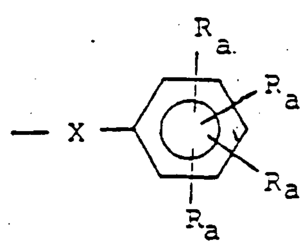

darstellt,

$R_a$ Wasserstoff, eine OH-Gruppe, Halogen, insbesondere Chlor oder Brom, oder eine niedere Alkylgruppe mit vorzugsweise l bis 4 C-Atomen darstellt, besonders bevorzugt Wasserstoff und OH-Gruppen, wobei mindestens zwei und höchstens sechs $R_a$-Gruppen OH-Gruppen sind,

X eine C-C-Bindung, -O-, -S-,

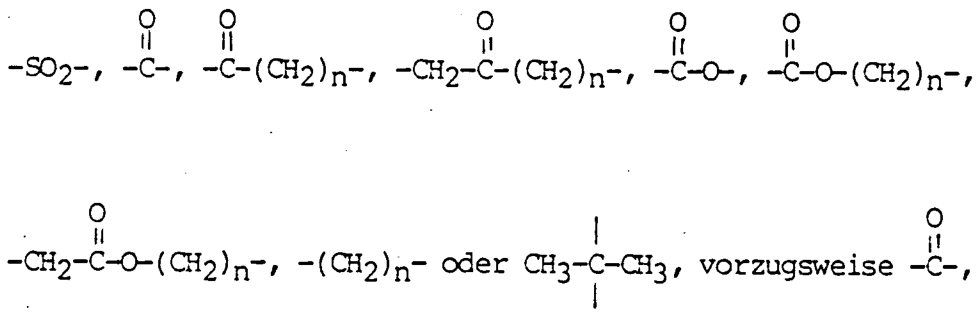

-$(CH_2)_n$-, oder, vorzugsweise

darstellt,

n 1 oder 2 bedeutet und

$R_b$ Wasserstoff oder eine gegebenenfalls substituierte Alkyl- oder Arylgruppe bedeutet, wobei die Alkylgruppe bevorzugt I bis 20, insbesondere I bis I2 C-Atome besitzt, die Arylgruppe bevorzugt eine Phenyl- oder eine Naphthylgruppe ist, und die Alkyl-, bzw. Arylgruppe als Substituenten gegebenenfalls niedere Alkylgruppen mit I bis 4 C-Atomen, niedere Alkoxygruppen mit I bis 4 C-Atomen oder Halogenatome, insbesondere Chlor oder Brom, aufweisen; besonders bevorzugt ist eine unsubstituierte Phenylgruppe;

II)

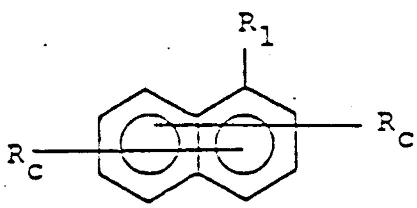

(II)

in der

$R_1$ Wasserstoff oder

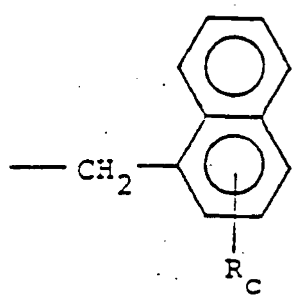

bedeutet und

$R_c$ Wasserstoff oder eine OH-Gruppe bedeutet, wobei mindestens zwei $R_c$-Gruppen OH-Gruppen sind; oder

III)

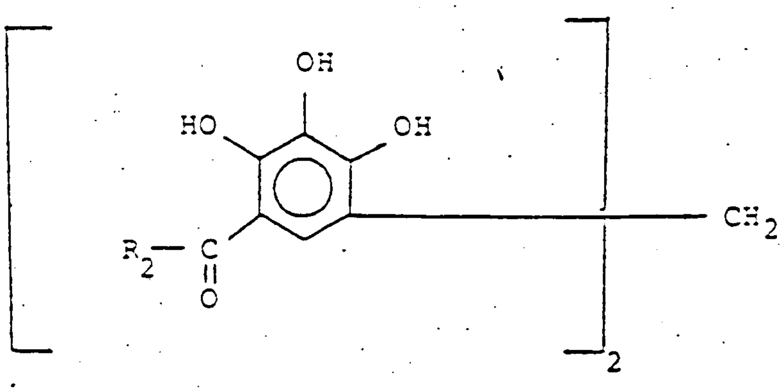

(III)

in der

$R_2$ Wasserstoff oder eine gegebenenfalls substituierte Alkyl- oder Arylgruppe bedeutet, wobei die Alkylgruppe bevorzugt I bis 20 C-Atome besitzt, gerade oder verzweigt sein kann und gegebenenfalls Halogenatome oder niedere Alkoxygruppen mit I bis 4 C-Atomen als Substituenten aufweist; die Arylgruppe bevorzugt I bis I0 C-Atome besitzt, bevorzugt einkernig ist und gegebenenfalls niedere Alkyl- oder Alkoxygruppen mit I bis 4 C-Atomen oder Halogenatome als Substituenten aufweist. Dabei werden Verbindungen, in denen $R_2$ eine Arylgruppe, insbesondere eine Phenylgruppe darstellt, bevorzugt.

Zu den Phenolverbindungen nach der allgemeinen Formel (I) zählen vorzugsweise:

Hydroxylgruppen tragende Benzolverbindungen, wie z.B.
I,2-Dihydroxybenzol,
I,3-Dihydroxybenzol,
I,4-Dihydroxybenzol,
I,2,3-Trihydroxybenzol,
I,2,4-Trihydroxybenzol,
I,3,5-Trihydroxybenzol;
Dihydroxybenzophenone, wie z.B.
2,2′-Dihydroxybenzophenon,
2,3′-Dihydroxybenzophenon,
2,4-Dihydroxybenzophenon,
2,4′-Dihydroxybenzophenon,
2,5-Dihydroxybenzophenon,
3,3′-Dihydroxybenzophenon,
4,4′-Dihydroxybenzophenon;
Trihydroxybenzophenone, wie z.B.
2,2′,6-Trihydroxybenzophenon,
2,3,4-Trihydroxybenzophenon,
2,4,4′-Trihydroxybenzophenon,
2,4,6-Trihydroxybenzophenon,
3,4,5-Trihydroxybenzophenon;
Tetrahydroxybenzophenone, wie z.B.
2,2′,3,4-Tetrahydroxybenzophenon,
2,2′4,4′-Tetrahydroxybenzophenon,
2,2′,4,6′-Tetrahydroxybenzophenon,
2,2′,5,6′-Tetrahydroxybenzophenon,
2,3′,4,4′-Tetrahydroxybenzophenon,
2,3′,4,6-Tetrahydroxybenzophenon,
2,4,4′,6-Tetrahydroxybenzophenon,
3,3′,4,4′-Tetrahydroxybenzophenon;
Pentahydroxybenzophenone;
Hexahydroxybenzophenone;
Dihydroxy- und Trihydroxy-phenyl-alkyl-ketone, wie z.B.
2,4-Dihydroxyphenyl-alkyl-ketone,
2,5-Dihydroxyphenyl-alkyl-ketone,

3,4-Dihydroxyphenyl-alkyl-ketone,
3,5-Dihydroxyphenyl-alkyl-ketone,
2,3,4-Trihydroxyphenyl-alkyl-ketone,
3,4,5-Trihydroxyphenyl-alkyl-ketone,
2,4,6-Trihydroxyphenyl-alkyl-ketone.
wobei vorzugsweise Alkylgruppen mit l bis l2 C-Atomen, die gegebenenfalls verzweigt sind, eingesetzt werden, wie z.B. Methyl, Ethyl, Butyl, n-Hexyl, Heptyl, Decyl, Dodecyl;
Dihydroxyphenyl-aralkyl-ketone;
Trihydroxyphenyl-aralkyl-ketone;
Dihydroxydiphenyle;
Trihydroxydiphenyle, wie z.B.
2,2′,4-Trihydroxydiphenyl;
Tetrahydroxydiphenyle, wie z.B.
2,2′,4,4′-Tetrahydroxydiphenyl;
Dihydroxydiphenylether;
Dihydroxydibenzylether;
Dihydroxydiphenylalkane, vorzugsweise mit niederen Alkylenketten, wie z.B. Methylen, Ethylen, Propylen;
Dihydroxybenzoesäure;
Trihydroxybenzosäuren;
Dihydroxy- und Trihydroxy-benzoesäurealkylester, wobei die Alkylgruppe vorzugsweise l bis l2 C-Atome, insbesondere 1 bis 8 C-Atome besitzt, wie z.B.
n-Butyl-2,4-, -2,5-, -3,4- und -3,5-dihydroxybenzoat,
2,4,4-Trimethylpentyl-2,4-dihydroxybenzoat;
Dihydroxy- und Trihydroxybenzoesäurephenylester;
Dihydroxy-, Trihydroxy-, und Tetrahydroxydiphenylsulfide, wie z.B. 4,4′-Dihydroxydiphenylsulfid;
Dihydroxydiphenylsulfone;
Dihydroxy- und Trihydroxyphenylnaphthylketone, wie z.B.
2,3,4-Trihydroxyphenylnaphthyl-1-keton;
und ähnliche Verbindungen.

Zu den Verbindungen der allgemeinen Formel (I), bei denen wenigstens eine $R_a$-Gruppe ein Halogenatom oder eine niedere Alkylgruppe darstellt, gehören beispielsweise
2,4-Dihydroxy-3,5-dibrombenzophenon,
5-Brom-2,4-dihydroxybenzoesäure und ihre Ester,
2,4,2′,4′-Tetrahydroxy-3,5,3′,5′-tetrabromdiphenyl,
4,4′-Dihydroxy-2,2′-dimethyl-5,5′-di-tert.-butyldiphenyl,
4,4′-Dihydroxy-2,2′-dimethyl-5,5′-di-tert.butyldiphenylsulfid,
2,4,2′,4′-Tetrahydroxy-3,5,3′,5′-tetrabromdiphenylsulfon und ähnliche Verbindungen.

Die Hydroxylgruppen enthaltenden Benzophenone, insbesondere die Trihydroxybenzophenone, werden als Phenolverbindungen der allgemeinen Formel (I) bevorzugt eingesetzt.

Zu den Phenolverbindungen der allgemeinen Formel (II) gehören vorzugsweise folgende Verbindungen:
Dihydroxynaphthaline, wie z.B.
l,2-Dihydroxynaphthalin,
l,4-Dihydroxynaphthalin,
l,5-Dihydroxynaphthalin,
l,6-Dihydroxynaphthalin,
l,7-Dihydroxynaphthalin,
l,8-Dihydroxynaphthalin,
2,3-Dihydroxynaphthalin,
2,6-Dihydroxynaphthalin,
2,7-Dihydroxynaphthalin;
Dihydroxydinaphthylmethane, wie z.B.
2,2′-Dihydroxydinaphthylmethan usw.
Die Dihydroxynaphthaline werden bevorzugt eingesetzt.
Die Hydroxylgruppen der Dihydroxynaphthaline können sich dabei sowohl an einem Kern, als auch an beiden Kernen des Naphthalinmoleküls befinden.

Zu den Phenolverbindungen der allgemeinen Formel (III) gehören vorzugsweise folgende Verbindungen:
Bis-(3-benzoyl-4,5,6-trihydroxyphenyl)-methan,

Bis-(3-acetyl-4,5,6-trihydroxyphenyl)-methan,
Bis-(3-propionyl-4,5,6-trihydroxyphenyl)-methan,
Bis-(3-butyryl-4,5,6-trihydroxyphenyl)-methan,
Bis-(3-hexanoyl-4,5,6-trihydroxyphenyl)-methan,
Bis-(3-heptanoyl-4,5,6-trihydroxyphenyl)-methan,
Bis-(3-decanoyl-4,5,6-trihydroxyphenyl)-methan und
Bis-(3-octadecanoyl-4,5,6-trihydroxyphenyl)-methan.

Die organischen Säurehalogenide, die neben den 1,2-Naphthochinon-5-sulfonsäurechloriden zur Herstellung der Mischester herangezogen werden, entsprechen der allgemeinen Formel IV

$W\text{-}R_3$ (IV)

in der

W

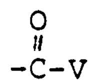

oder $-SO_2-V$ darstellt, wobei V Halogen, insbesondere Chlor oder Brom, bedeutet und

$R_3$ eine gegebenenfalls substituierte Alkyl-oder Arylgruppe darstellt; dabei besitzen die Alkylgruppen bevorzugt 1 bis 20 C-Atome, sind gerade- oder verzweigtkettig und weisen gegebenenfalls Halogenatome, insbesondere Brom oder Chlor, oder niedere Alkoxygruppen mit 1 bis 4 C-Atomen als Substituenten auf; die Arylgruppen besitzen bevorzugt 6 bis 10 C-Atome, sind bevorzugt einkernig und weisen gegebenenfalls niedere Alkyl- oder Alkoxygruppen mit 1 bis 4 C-Atomen oder Halogenatome, bevorzugt Brom oder Chlor, als Substituenten auf; Phenylgruppen werden bevorzugt; ganz besonders werden Alkylgruppen, insbesondere niedere Alkylgruppen mit 1 bis 6 C-Atomen, bevorzugt.

Zu den organischen Säurehalogeniden der vorstehenden Formel zählen beispielsweise
Alkylsulfonylhalogenide, wie z.B.
Methansulfonylchlorid,
Ethansulfonylchlorid,
Propansulfonylchlorid,
n-Butansulfonylchlorid,
Dodecansulfonylchlorid;
Arylsulfonylchloride, wie z.B.
Benzolsulfonylchlorid,
Naphthalinsulfonylchloride;
Acylhalogenide, wie z.B.
Acetylchlorid,
Butanoylchlorid,
Valeroylchlorid,
Benzoylchlorid,
Benzoylbromid,
Naphthoylchloride.

Bevorzugt werden niedere Alkylsulfonylhalogenide und niedere Alkylacylhalogenide mit 1 bis 6 C-Atomen, sowie Benzolsulfonylhalogenide und Benzoylhalogenide. Die Säurehalogenide können gegebenenfalls substituiert sein.

Die Herstellung der erfindungsgemäßen lichtempfindlichen Gemische, insbesondere von Photoresists, erfolgt durch Mischen der lichtempfindlichen Verbindungen mit alkalilöslichen Harzen, Lösemitteln und gegebenenfalls weiteren Zusätzen. Geeignete alkalilösliche Harze sind beispielsweise Novolake und Polyvinylphenole.

Alkalilösliche Novolake, die für die Herstellung von lichtempfindlichen Gemischen verwendet werden können, sind bekannt. Ein Verfahren zur Herstellung dieser Novolake ist in "Chemistry and Application of Phenolic Resins" (Chemie und Anwendung von Phenolharzen), von A. Knop und W. Scheib, Springer Verlang, New York, l979, Kapitel 4, beschrieben.

Für die Herstellung der erfindungsgemäßen lichtempfindlichen Gemische werden der Novolak oder das Polyvinylphenol und die lichtempfindliche Verbindung in einem Lösemittel gelöst. Hierfür geeignete Lösemittel sind beispielsweise Glykolether, wie z.B. Ethylenglykolmonomethylether und Ethylenglykolmonoethylether oder auch deren Acetate wie Propylenglykolmethyletheracetat; Ester, wie z.B. Ethylacetat und Butylacetat; Ketone, wie z.B. Methylethylketon, Cyclopentanon und Cyclohexanon sowie aromatische Kohlenwasserstoffe, wie z.B. Toluol und Xylol. Gemische aus diesen Lösemitteln können ebenfalls eingesetzt werden. Die genaue Auswahl des Lösemittels, bzw. Lösemittelgemisches, hängt im Einzelfall unter anderem von dem jeweiligen Beschichtungsverfahren, der gewünschten Schichtdicke, den Trocknungsbedingungen, der Löslichkeit der einzelnen Komponenten und der Verdunstungsgeschwindigkeit des Lösemittels nach der Beschichtung des Trägers mit dem Photoresistgemisch ab.

Dem erfindungsgemäßen lichtempfindlichen Gemisch können vor dem Aufbringen auf einen Schichtträger noch Zusätze, wie z.B. Farbmittel, Farbstoffe, Verlaufmittel, Weichmacher, Haftvermittler, Entwicklungsbeschleuniger und Tenside, z.B. nichtionische Tenside, zugegeben werden.

In bevorzugter Ausführung liegt der Gehalt an festen Bestandteilen des lichtempfindlichen Gemisches für den Novolak oder das Polyvinylphenol bei etwa 15 bis 99 Gewichtsprozent, für die lichtempfindliche Verbindung bei etwa l bis 85 Gewichtsprozent. Insbesondere ist das Bindemittel in einem Anteil von etwa 50 bis 97 Gewichtsprozent, und ganz besonders bevorzugt von etwa 65 bis 93 Gewichtsprozent, bezogen auf das Gewicht der festen Bestandteile, in dem Gemisch enthalten. Der Anteil an lichtempfindlicher Verbindung liegt insbesondere bei etwa 3 bis 50 Gewichtsprozent und ganz besonders bevorzugt bei etwa 7 bis 35 Gewichtsprozent, bezogen auf das Gewicht der festen Bestandteile des Gemischs. Zur Herstellung des lichtempfindlichen Gemisches werden das Bindemittel und und die lichtempfindliche Verbindung so mit dem Lösemittel gemischt, daß das Lösemittel in einem Anteil von etwa 40 bis 90 Gewichtsprozent, vorzugsweise von etwa 60 bis 85 Gewichtsprozent, und insbesondere von etwa 65 bis 80 Gewichtsprozent, jeweils bezogen auf das Gewicht des gesamten Gemisches, vorhanden ist.

Farbstoffe, die als Zusätze für die erfindungsgemäßen Photoresistgemische verwendet werden können, sind zum Beispiel Methylviolett 2B (C.I. 42 535), Kristallviolett (C.I. 42 555), Malachitgrün (C.I. 42 000), Victoriablau B (C.I. 44 045) und Neutralrot (C.I. 50 040). Diese Farbstoffe werden in einer Menge von l bis l0 Gewichtsprozent, bezogen auf das gemeinsame Gewicht von Bindemittel und lichtempfindlicher Verbindung, zugesetzt. Die Farbstoffzusätze verringern die Rückstreuung von Licht vom Träger und tragen so zu einer verbesserten Auflösung bei.

Verlaufmittel können in einer Menge bis zu 5 Gewichtsprozent, bezogen auf das gemeinsame Gewicht von Bindemittel und lichtempfindlicher Verbindung, eingesetzt werden.

Geeignete Weichmacher sind zum Beispiel Phosphorsäuretri($\beta$-chlorethyl)-ester, Stearinsäure, Dicampher, Polypropylen, Acetalharze, Phenoxyharze und Alkydharze, die in Anteilen von l bis l0 Gewichtsprozent, bezogen auf das gemeinsame Gewicht von Bindemittel und lichtempfindlicher Verbindung, zugesetzt werden können. Die Weichmacherzusätze verbessern die Beschichtungseigenschaften des Gemischs und ermöglichen das Auftragen in einer glatten und gleichmäßig dicken Schicht auf den Schichtträger.

Geeignete Haftvermittler zur besseren Haftung des Gemisches auf dem Träger sind zum Beispiel $\beta$-(3,4-Epoxycyclohexyl)-ethyltrimethoxysilan, p-Methyldisilanmethylmethacrylat, Vinyltrichlorsilan und $\gamma$-Aminopropyltriethoxysilan in einem Anteil bis zu 4 Gewichtsprozent, bezogen auf das gemeinsame Gewicht von Bindemittel und lichtempfindlicher Verbindung.

Als Entwicklungsbeschleuniger können beispielsweise Pikrinsäure, Nicotinsäure oder Nitrozimtsäure in einem Anteil bis zu 20 Gewichtsprozent, bezogen auf das gemeinsame Gewicht von Bindemittel und lichtempfindlicher Verbindung, zugegeben werden. Diese Beschleuniger führen dazu, daß die Löslichkeit der lichtempfindlichen Schicht sowohl in den belichteten als auch in den unbelichteten Bereichen zunimmt. Sie werden deshalb bei solchen Anwendungen eingesetzt, bei denen es in erster Linie auf die Entwicklungsgeschwindigkeit ankommt. Während die belichteten Bereiche der Photoresistschicht durch den Zusatz von Beschleunigern vom Entwickler schneller gelöst werden, bewirken die Entwicklungsbeschleuniger gleichzeitig aber auch einen größeren Verlust an Photoresistschicht aus den unbelichteten Bereichen, so daß eventuell ein gewisser Grad an Kontrast verloren geht.

Als nicht-ionische Tenside können zum Beispiel Nonylphenoxy-poly(ethylenoxy)-ethanol,
Octylphenoxy(ethylenoxy)-ethanol, und
Dinonylphenoxy-poly(ethylenoxy)-ethanol in einem Anteil bis zu l0 Gewichtsprozent, bezogen auf das gemeinsame Gewicht vom Bindemittel und lichtempfindlicher Verbindung, verwendet werden.

Erfindungsgemäß wird ferner ein lichtempfindliches Aufzeichnungsmaterial vorgeschlagen, im wesentlichen bestehend aus dem oben beschriebenen lichtempfindlichen Gemisch und einem Träger, sowie ein Verfahren zur Herstellung einer Photoresistschablone unter Verwendung des Aufzeichnungsmaterials:
Das lichtempfindliche Gemisch kann nach einem der in der Photoresisttechnik üblichen Verfahren, wie Tauchen, Sprühen und Aufschleudern, auf einen Träger aufgebracht werden. Beim Aufschleudern kann zum Beispiel der Prozentanteil an Feststoffen in der Resistlösung so eingestellt werden, daß sich in Abhängigkeit

von der im Einzelfall verwendeten Aufschleudervorrichtung und der für den Aufschleudervorgang angesetzten Zeitspanne eine Beschichtung in der gewünschten Dicke ergibt. Beispiele für geeignete Trägermaterialien sind: Silicium, Aluminium oder polymere Harze, Siliciumdioxid, dotiertes Siliciumdioxid, Siliciumnitrid, Tantal, Kupfer, polykristallines Silicium (polysilicon), Keramik und Aluminium/Kupfer-Legierungen.

Die nach dem beschriebenen Verfahren hergestellten lichtempfindlichen Gemische eignen sich insbesondere zum Auftragen auf Silicium-Wafern, die eine Schicht aus thermisch gezüchtetem Siliciumdioxid tragen, wie sie bei der Herstellung von Mikroprozessoren und anderen in der Mikroelektronik verwendeten Halbleiterbauelementen verwendet werden. Ebenso kann auch ein Wafer aus Aluminium mit einer Aluminiumoxidschicht eingesetzt werden. Der Träger kann auch aus verschiedenen polymeren Harzen, insbesondere aus transparenten Polymeren, wie zum Beispiel Polyestern, bestehen.

Nach dem Auftragen des lichtempfindlichen Gemisches auf den Schichtträger wird der Träger einer Vortrocknung bei etwa 80 bis l05 °C unterworfen. Diese Wärmebehandlung wird so lange fortgeführt, bis das Lösemittel im wesentlichen vollständig verdampft ist und eine dünne Schicht von etwa l µm auf dem Schichtträger zurückbleibt.

Der beschichtete Träger wird anschließend in bekannter Weise mittels aktinischer Strahlung, insbesondere UV-Strahlung, durch geeignete Masken, Negative, Schablonen, usw. bildmäßig belichtet.

Die bildmäßig belichteten Aufzeichnungsmaterialien werden in eine wäßrig-alkalische Entwicklerlösung getaucht, wobei die Lösung vorzugsweise durch Durchblasen von Stickstoff stark bewegt wird.

Nach dem Herausnehmen der entwickelten Wafer aus der Entwicklerlösung kann eine Wärmenachbehandlung bzw. Einbrennbehandlung durchgeführt werden, um die Haftung und die chemische Beständigkeit der Schicht gegen Ätzlösungen und andere Substanzen zu erhöhen. Die Wärmebehandlung nach dem Entwickeln kann aus einer Ofenhärtung von Schicht und Träger bei Temperaturen unterhalb des Erweichungspunktes der Schicht bestehen.

Für industrielle Anwendungen, insbesondere bei der Herstellung von Halbleiterbauelementen auf Siliciumträgern mit einer Siliciumdioxidschicht können die entwickelten Träger mit einer gepufferten Ätzlösung auf der Basis von Flußsäure behandelt werden. Die erfindungsgemäßen Photoresistgemische sind gegen derartige Ätzlösungen auf Säurebasis resistent und gewährleisten einen wirksamen Schutz der unbelichteten, mit dem Photoresistgemisch beschichteten Stellen des Trägers.

Die erfindungsgemäßen lichtempfindlichen Gemische eignen sich bevorzugt als Photoresistgemische. Sie können allerdings auch als lichtempfindliche Gemische für die Druckplattenherstellung und für Farbprüffolien Verwendung finden.

Herstellung lichtempfindlicher Verbindungen

Die Herstellung von lichtempfindlichen Verbindungen auf der Basis von Naphthochinondiaziden ist beispielhaft in US-A-3,046,ll8, US-A-3,l06,645 und US-A-4,397,937 beschrieben. Die lichtempfindlichen Verbindungen für das erfindungsgemäße lichtempfindliche Gemisch werden durch Kondensation des 1,2-Naphthochinon-2-diazid-5-sulfonsäurechlorids und des organischen Säurehalogenids mit einer mehr als eine Hydroxylgruppe enthaltenden Phenolverbindung des Typs I bis III in Gegenwart einer säurebindenden Substanz hergestellt. Die so erhaltenen lichtempfindlichen Verbindungen können gegebenenfalls noch gereinigt werden.

Für die Durchführung der Reaktion geeignete Lösungsmittel sind beispielsweise Aceton, p-Dioxan, Tetrahydrofuran, Methylenchlorid, Pyridin, usw.

Die Säure bindende Substanz kann anorganisch sein, z.B. Natriumcarbonat, oder organisch, z.B. ein Natriumsalz einer schwachen organischen Säure, ein tertiäres Amin, z.B. Triethylamin oder ein Pyridin(derivat).

Beispiel l

23,0 g 2,3,4-Trihydroxybenzophenon und 37,6 g l,2-Naphthochinondiazid5-sulfonsäurechlorid (Diazoverbindung) werden in 165 ml Aceton miteinander verrührt. 20,5 g Methansulfonylchlorid werden hinzugefügt. Dann werden 34,0 g Triethylamin langsam tropfenweise zugegeben, wobei die Innentemperatur bei 30 °C gehalten wird. Anschließend wird das Reaktionsgemisch filtriert, mit 165 ml Aceton gewaschen und in 3,5 Liter l N Salzsäure aufgenommen. Das Reaktionsprodukt wird abgefiltert, mit Wasser gewaschen und in einem Umluftschrank bei einer Temperatur unter 40 °C getrocknet. Die Ausbeute beträgt 67,8 g, entsprechend 99,7 % d.Th.

Das so erhaltene Produkt kann gegebenenfalls noch gereinigt werden.

Das beschriebene Herstellungsverfahren ist nicht das einzig mögliche. Jeder Fachmann kann durch

Variieren der verwendeten Lösemittel, Basen oder Reaktionsbedingungen ohne weiteres zu vergleichbaren Produkten gelangen. In Tabelle 1 sind eine Reihe weiterer lichtempfindlicher Verbindungen angegeben.

Tabelle 1

| Lichtempfindl.(1) Verbindung | Trisester mit der Diazoverbindung (%) | 3,4 Bisester mit der Diazoverbindung (%) | Methansulfonyl-trisester (%) | Stickstoff (Diazo)-Gehalt (%) |
|---|---|---|---|---|
| A | 30,5 | 3,0 | 16,6 | 6,20 |
| B | 30,1 | 4,2 | 13,8 | 6,38 |
| C | 29,0 | 4,7 | 11,2 | 6,28 |
| D | 12,2 | 1,6 | 9,3 | 6,09 |
| E | 12,8 | 1,7 | 7,9 | 6,09 |
| F | 13,1 | 0,8 | 9,9 | 5,99 |
| G | 12,2 | 1,0 | 9,6 | 6,11 |
| H | 14,3 | 1,9 | 10,3 | 6,20 |
| I | 12,7 | 0,7 | 6,6 | 6,60 |
| J | 10,3 | 0,7 | 6,4 | 6,36 |
| K | 12,8 | 1,9 | 6,9 | 6,47 |
| L | 13,2 | 1,9 | 9,2 | 6,53 |
| M | 12,4 | 1,7 | 6,8 | 6,40 |
| N | 12,7 | 1,8 | 7,6 | 6,50 |
| O | 14,9 | - | 7,6 | 6,38 |
| P | 11,9 | 0,7 | 7,7 | 6,41 |

(1) Zur Herstellung der lichtempfindlichen Verbindungen A, B und C wird zunächst die Diazoverbindung mit 2,3,4-Trihydroxybenzophenon umgesetzt und dann das Methansulfonylchlorid zugegeben. Zur Herstellung der lichtempfindlichen Verbindungen M und O wird dagegen das Methansulfonylchlorid mit 2,3,4-Trihydroxybenzophenon umgesetzt und dann die Diazoverbindung zugegeben. Zur Herstellung der lichtempfindlichen Verbindungen D bis L sowie N und P werden die Diazoverbindung und das Methansulfonylchlorid gleichzeitig mit 2,3,4-Trihydroxybenzophenon kondensiert.

Beispiel 2

Zur Herstellung einer lichtempfindlichen Verbindung wird 1,2,3-Trihydroxybenzol in einem Molverhältnis

von 1:3 mit einem Gemisch aus 90 Mol-% Diazoverbindung und 10 Mol-% Methansulfonylchlorid kondensiert. 0,74 g der resultierenden lichtempfindlichen Verbindung werden in 24,26 g einer Lösung aus 28,4 % Novolak und 71,6 % eines Lösemittelgemisches aus Cellosolveacetat, Butylacetat und Xylol gegeben und die lithographischen Eigenschaften des auf diese Weise erhaltenen lichtempfindlichen Gemischs gemessen. Die Messung ergibt bei einem Absorptionsvermögen von 0,740 l/g•cm bei 398 nm einen Dunkelabtrag von 0,004 µm/min; die Lichtempfindlichkeit beträgt 31,0 mJ/cm$^2$, bestimmt bei 405 nm bei einer Breitbandbelichtung im Bereich von 350-450nm; der Kontrastwert beträgt 2,50. Die lichtempfindliche Lösung bleibt bei einer Lagerung bei Zimmertemperatur mindestens 2 Wochen stabil. Dagegen ist es nicht möglich, aus einer unmodifizierten lichtempfindlichen Verbindung, die durch Kondensation von 1,2,3-Trihydroxybenzol und Diazoverbindung in einem Molverhältnis von 1:3 erhalten wird, in Verbindung mit dem vorstehend verwendeten Novolak und Lösemittelgemisch eine stabile Lösung herzustellen.

Zum Vergleich wird 2,3,4-Trihydroxybenzophenon mit 1,2-Naphthochinondiazid-5-sulfonylchlorid in einem Molverhältnis von 1:1,4 kondensiert. Die erhaltene lichtempfindliche Verbindung hat einen Gehalt an Trisester mit der Diazoverbindung von 36 bis 40 Gew.-%, einen Gehalt an 3,4-Bisester mit der Diazoverbindung von 18 bis 20 Gew.-% und einen Gehalt an 2,3,4-Trihydroxybenzophenon von 9 bis 10 Gew.-%. In der nachfolgenden Tabelle 3 wird diese lichtempfindliche Verbindung mit "X" bezeichnet.

Die Löslichkeit der lichtempfindlichen Verbindungen wird geprüft, indem die einzelnen lichtempfindlichen Verbindungen in verschiedenen Konzentrationen in einem Lösemittel gelöst werden und die Lösungen mehrere Tage beobachtet werden. Die lichtempfindliche Verbindung G kristallisiert auch bei einer Konzentration von 30 % in Aceton nicht aus. Dagegen kristallisiert die lichtempflindliche Verbindung X bei Konzentrationen von 30 % und 15 % über Nacht aus. Auch bei einer Konzentration an lichtempfindlicher Verbindung X von 5 % tritt noch eine leichte Ausflockung auf.

Beispiele 3 bis 15

Nach dem bereits beschriebenen Verfahren werden lichtempfindliche Gemische hergestellt. Dazu werden die unterschiedlichen lichtempfindlichen Verbindungen in einer gefilterten Lösung aus Bindemittel und Propylenglykolmethyletheracetat (PGMEA) oder einem Lösemittelgemisch aus Cellosolveacetat, Butylacetat und Xylol (CBX) gelöst.

Die Zusammensetzung der einzelnen Gemische geht aus Tabelle 2 hervor.

Die lichtempfindlichen Gemische werden durch ein Alsop-Filter 175 und anschließend durch ein Fluoropore-Filter mit Filteröffnungen von 0,2 µm (Hersteller Millipore Corporation) gefiltert. Sie werden unter Lichtausschluß sieben Tage bei einer konstanten Temperatur von 50 °C gelagert. Anschließend wird geprüft, ob sich ein sichtbarer Niederschlag gebildet hat. Falls ja, hat die jeweilige Lösung die Stabilitätsprüfung nicht bestanden. Außerdem wird die Lösungsstabilität der lichtempfindlichen Gemische bei Zimmertemperatur untersucht. Dabei wird von Zeit zu Zeit geprüft, ob sichtbares Auskristallisieren, Ausfallen oder ein Farbumschlag stattgefunden hat.

Tabelle 2

| Beispiel Nr. | Lichtempfindl. Verbindung (Gew.-%) | | Bindemittellösung | Diazoverbindung Kontrast des lichtempfindlichen Gemisches |
|---|---|---|---|---|
| 3 | A | 9,12 | 24 % Novolak/76% PGMEA | 0,565 % |
| 4 | B | 8,88 | 24 % Novolak/76% PGMEA | 0,565 % |
| 5 | C | 9,00 | 24 % Novolak/76% PGMEA | 0,565 % |
| 6 | D | 9,29 | 24 % Novolak/76% PGMEA | 0,565 % |
| 7 | E | 9,3 | 24 % Novolak/76% PGMEA | N/A |
| 8 | F | 9,3 | 24 % Novolak/76% PGMEA | N/A |
| 9 | G | 9,3 | 24 % Novolak/76% PGMEA | N/A |
| 10 | N | 9,3 | 24 % Novolak/76% PGMEA | N/A |
| 11 | O | 9,3 | 24 % Novolak/76% PGMEA | N/A |
| 12 | P | 9,3 | 24 % Novolak/76% PGMEA | N/A |
| 13 | N | 8,825 | 25,6 % Novolak/74,4 % CBX | N/A |
| 14 | O | 8,825 | 25,6 % Novolak/74,4 % CBX | N/A |
| 15 | P | 8,825 | 25,6 % Novolak/74,4 % CBX | N/A |

Die erfindungsgemäßen lichtempfindlichen Gemische zeichnen sich durch eine hervorragende Lösungsstabilität und Farbbeständigkeit aus. Bei den Gemischen der Beispiele 3 bis 15 ist nach einer 7-tägigen Lagerung bei 50 °C keine sichtbare Ausfällung feststellbar. Bei Lagerung bei Zimmertemperatur ist bei den Proben der Beispiele 3 bis 10, 12, 13 und 15 auch nach sieben Monaten kein Niederschlag erkennbar. Bei der Probe nach Beispiel 11 ist nach vier Monaten ein Niederschlag erkennbar, und bei der Probe nach Beispiel 14 ist nach sechs Monaten ein Niederschlag erkennbar. Im Vergleich mit lichtempfindlichen Gemischen, in denen lichtempfindliche Verbindungen des Typs X (vgl. Tabelle 3) enthalten sind, besitzen die erfindungsgemäßen Gemische eine außergewöhnlich klare, helle Farbe.

Durch die Wahl des Lösemittelsystems kann die Möglichkeit zur Herstellung einer Lösung aus einer bestimmten lichtempfindlichen Verbindung beeinflußt werden. Es kommt vor, daß eine lichtempfindliche Verbindung in einem Lösemittelsystem nur schwerlöslich ist, während sie in einem anderen Lösemittelsystem ohne Schwierigkeiten gelöst werden kann. Es ist jedoch allgemein so, daß in Lösemittelsystemen, in denen sowohl die unmodifizierte als auch die entsprechende modifizierte lichtempfindliche Verbindung löslich ist, die unmodifizierte lichtempfindliche Verbindung schneller zum Ausfallen neigt.

Beispiele 16 bis 41

Aus den lichtempfindlichen Verbindungen werden lichtempfindliche Gemische hergestellt, indem die jeweils zu prüfende lichtempfindliche Verbindung in einer gefilterten Stammlösung aus Bindemittel und Lösemittel gelöst wird. Anschließend werden die Gemische filtriert und zu einer Trockenschichtdicke von 2,0 µm auf Siliciumwafer aufgeschleudert. Die Wafer werden bei 90 °C 30 Minuten getrocknet.

Die ursprüngliche Dicke der Photoresistschichten wird mit einem Rudolph-Dickenmeßgerät ermittelt. Anschließend wird mit unterschiedlichen Dosen UV-Licht (350-450 nm) belichtet. Die Photoresists werden l Minute bei 25 °C mit alkalischem Entwickler E1, E2 oder E3, der mit entionisiertem Wasser verdünnt wurde, entwickelt. Die verbliebene Schichtdicke wird gemessen und so der bei der jeweiligen Energiedosis auftretende Schichtverlust bestimmt.

Die Lichtempfindlichkeit wird anhand einer Kennkurve nach R.W. Wake und M.C. Flanigan, "A Review of Contrast in Positive Photoresists," SPIE Bd. 539, Advances in Resist Technology and Processing II (l985, S. 29l) gemessen, wobei der Schichtdickenverlust nach einer Entwicklungsdauer von einer Minute gegen den Logarithmus der UV-Belichtungsdosis aufgetragen wird. Durch Interpolieren dieser Kurve auf einen Schichtdickenverlust von l µm wird der jeweilige Lichtempfindlichkeitswert in $mJ/cm^2$ erhalten. Die Neigung des linearen Teils der Kurve gibt den Kontrast an.

Die Ergebnisse, die bei der Prüfung der Lichtempfindlichkeit, des Konstrasts und des Dunkelabtrags mehrerer Photoresistgemische erzielt werden, in denen erfindungsgemäß lichtempfindliche Verbindungen enthalten sind, sind in Tabelle 3 zusammenfassend dargestellt und werden mit Photoresistgemischen verglichen, die die lichtempfindliche Verbindung X enthalten.

Tabelle 3

| Beispiel Nr. | Lichtempfindl. Verbindung (Gew.-%) | | Bindemittel Lösemittel | Absorptionsvermögen (1/g·cm) | Entwickler(1) | Entwicklerkonzentration (Verhältnis zu $H_2O$) | Dunkelabtrag (µm/min) | Lichtempfindlichkeit(2) (mJ/cm²) | Kontrast |
|---|---|---|---|---|---|---|---|---|---|
| 16 | X | 3,9 | 30 % Novolak 70 % CHX | 0,741 | E2 | 1:1,5 | 4 | 43,1 | 1,48 |
| 17 | D | 4,9 | 30 % Novolak 70 % CHX | 0,727 | E2 | 1:1 | 3 | 43,2 | 1,90 |
| 18 | X | 3,9 | 30 % Novolak 70 % CHX | 0,745 | E1 | 1:5 | 8 | 27,6 | 2,27 |
| 19 | D | 4,9 | 30 % Novolak 70 % CHX | 0,736 | E1 | 1:4 | 4 | 33,6 | 2,55 |
| 20 | X | 6,9 | 30 % Novolak 70 % CHX | 1,30 | E1 | 1:4 | 4 | 14,2 | 3,04 |
| 21 | D | 8,8 | 30 % Novolak 70 % CHX | 1,35 | E1 | 1:2 | 4 | 15,1 | 4,03 |
| 22 | X | 6,9 | 30 % Novolak 70 % CHX | 1,30 | E3 | 1:1,5 | 6 | 26,3 | 2,21 |
| 23 | D | 6,9 | 30 % Novolak 70 % CHX | 1,30 | E3 | 1:1,5 | 7 | 26,1 | 2,29 |
| 24 | X | 6,87 | 25,6 % Novolak 74,4 % CHX | 1,31 | E3 | 1:1,5 | 8 | 24,1 | 2,23 |
| 25 | D | 7,16 | 30 % Novolak 70 % CHX | 1,33 | E3 | 1:1,5 | 9 | 25,2 | 2,37 |
| 26 | X | 7,12 | 30 % Novolak 70 % CHX | 1,31 | E3 | 1:1,5 | 2 | 38,7 | 2,04 |

Fortsetzung Tabelle 3

| Beispiel Nr. | Lichtempfindl. Verbindung (Gew.-%) | | Bindemittel Lösemittel | Absorptionsvermögen (1/g·cm) | Entwickler(1) | Entwicklerkonzentration (Verhältnis zu $H_2O$) | Dunkelabtrag (µm/min) | Lichtempfindlichkeit(2) ($mJ/cm^2$) | Kontrast |
|---|---|---|---|---|---|---|---|---|---|
| 27 | D | 7,12 | 25,6 % Novolak<br>74,4 % CBX | 1,31 | E3 | 1:1,5 | 8 | 25,8 | 2,38 |
| 28 | D | 8,66 | 30 % Novolak<br>70 % CBX | 1,32 | E3 | 1:1 | 9 | 21,2 | 4,00 |
| 29 | X | 8,8 | 30 % Novolak<br>70 % CBX | 1,35 | E3 | 1:1 | 15 | 29,9 | 3,71 |
| 30 | D | 8,8 | 30 % Novolak<br>70 % CBX | 1,35 | E3 | 1:1 | 5 | 27,5 | 4,18 |
| 31 | X | 8,82 | 25,6 % Novolak<br>74,4 % CBX | 1,33 | E3 | 1:1 | 5 | 29,9 | 3,74 |
| 32 | D | 8,82 | 30 % Novolak<br>70 % CBX | 1,35 | E3 | 1:1 | 8 | 27,4 | 4,09 |
| 33 | X | 8,82 | 25,6 % Novolak<br>74,4 % CBX | 1,36 | E3 | 1:1 | 6 | 29,5 | 4,02 |
| 34 | D | 9,24 | 30 % Novolak<br>70 % CBX | 1,32 | E3 | 1:1 | 6 | 30,6 | 4,42 |
| 35 | X | 9,24 | 30 % Novolak<br>70 % CBX | 1,32 | E2 | 1:1 | 6 | 31,8 | 4,54 |
| 36 | E | 9,24 | 30 % Novolak<br>70 % CBX | 1,34 | E3 | 1:1 | 5 | 31,0 | 4,50 |
| 37 | F | 9,24 | 30 % Novolak<br>70 % CBX | 1,33 | E3 | 1:1 | 5 | 31,4 | 4,41 |

Fortsetzung Tabelle 3

| Beispiel Nr. | Lichtempfindl. Verbindung (Gew.-%) | Bindemittel Lösemittel | Absorptionsvermögen (1/g·cm) | Entwickler(1) | Entwickler-konzentration (Verhältnis zu $H_2O$) | Dunkelabtrag (µm/min) | Lichtempfindlichkeit(2) ($mJ/cm^2$) | Kontrast |
|---|---|---|---|---|---|---|---|---|
| 38 | G 9,24 | 30 % Novolak<br>70 % CBX | 1,32 | E3 | 1:1 | 6 | 31,5 | 4,57 |
| 39 | N 8,82 | 24,6 % Novolak<br>74,4 % CBX | 1,36 | E3 | 1:1 | 8 | 30,0 | 4,17 |
| 40 | O 8,82 | 24,6 % Novolak<br>74,4 % CBX | 1,35 | E3 | 1:1 | 9 | 30,9 | 3,89 |
| 41 | P 8,82 | 24,6 % Novolak<br>74,4 % CBX | 1,35 | E3 | 1:1 | 7 | 31,2 | 3,88 |

(1) E1 ist ein anorganischer wäßrig-alkalischer Entwickler, E2 ist ein anorganischer gepufferter wäßrig-alkalischer Entwickler und E3 ist ein metallionenfreier wäßrig-alkalischer Entwickler, der ein quaternäres Ammoniumsalz enthält.

(2) Belichtung mittels Breitbandbelichtung, gemessen bei 365 nm.

Aus Tabelle 3 geht hervor, daß die erfindungsgemäßen Photoresistgemische bei Entwicklung mit einem wäßrig-alkalischen Entwickler höhere Kontrastwerte aufweisen als die Gemische mit der lichtempfindlichen Verbindung X (Vergleichsbeispiele), wobei die Lichtempfindlichkeitswerte der Gemische in etwa gleich sind.

Beim Entwickeln der erfindungsgemäßen Gemische mit einem metallionenfreien Entwickler wird festgestellt, daß die Induktionszeit bis zu 50 % länger ist als bei Verwendung der Vergleichsgemische. (Die

Induktionszeit ist ein Grenzwert und gibt die Zeitspanne an, die vergeht, bis die belichteten Resistbereiche im Entwickler löslich werden. Sie kann durch Auftragen des Schichtverlustes gegen den Logarithmus der jeweiligen Belichtungsenergie ermittelt werden).

## Patentansprüche

1. Lichtempfindliches Gemisch, enthaltend ein in wäßrigen Systemen unlösliches, in wäßrig alkalischen und organischen Lösemitteln lösliches, zumindest aber quellbares Bindemittel sowie eine lichtempfindliche Verbindung, dadurch gekennzeichnet, daß die lichtempfindliche Verbindung ein Kondensationsprodukt ist aus einer Phenolverbindung der Formel I

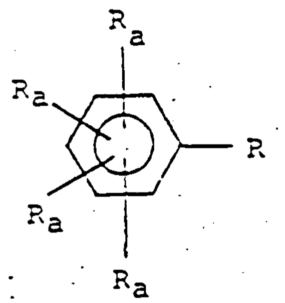

(I)

in der

R Wasserstoff, $-X-R_b$ oder

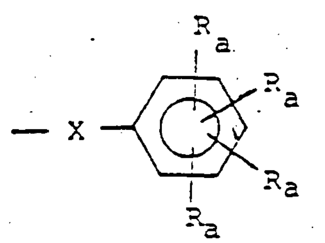

darstellt,

$R_a$ Wasserstoff, eine OH-Gruppe, Halogen oder eine niedere Alkylgruppe darstellt, wobei mindestens zwei und höchstens sechs $R_a$-Gruppen OH-Gruppen sind,

X eine C-C-Bindung, -O-, -S-,

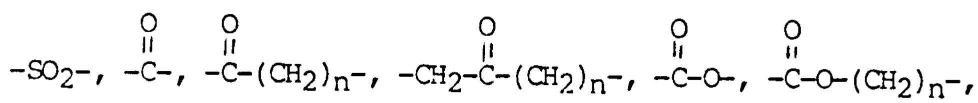

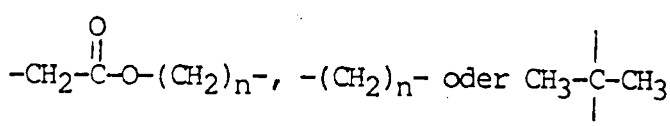

darstellt,

n 1 oder 2 bedeutet und

$R_b$ Wasserstoff oder eine gegebenenfalls substituierte Alkyl- oder Arylgruppe bedeutet;

oder der Formel II

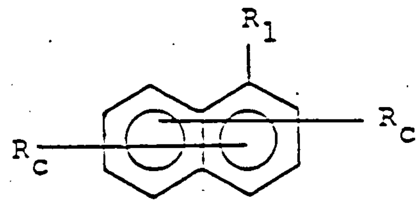 (II)

in der

R₁ Wasserstoff oder

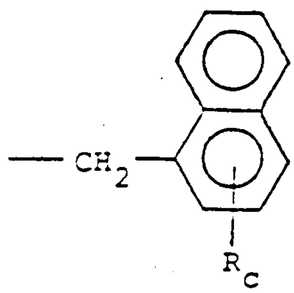

bedeutet und

$R_c$ Wasserstoff, oder eine OH-Gruppe bedeutet, wobei mindestens zwei $R_c$-Gruppen OH-Gruppen sind;

oder der Formel III

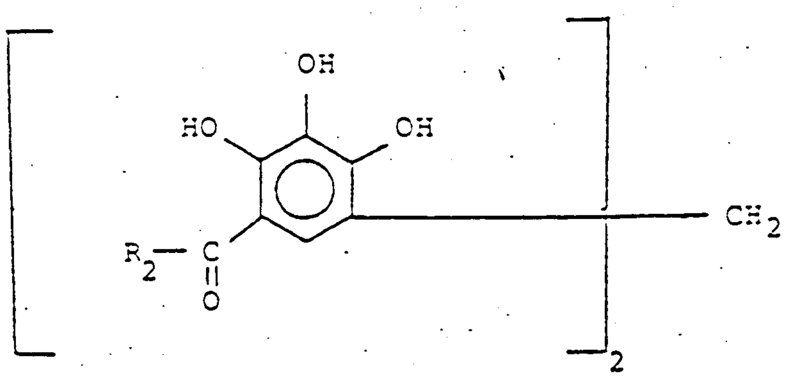 III

in der

$R_2$ Wasserstoff oder eine gegebenenfalls substituierte Alkyl- oder Arylgruppe bedeutet;

mit einer Mischung aus einem l,2-Naphthochinondiazid-5-sulfonsäurechlorid (Diazoverbindung) und einem organischen Säurehalogenid der Formel IV

$W-R_3$ (IV)

in der

W

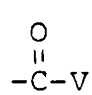

oder $-SO_2-V$ bedeutet, wobei V ein Halogen darstellt, und

$R_3$ eine gegebenfalls substituierte Alkyl- oder Arylgruppe bedeutet.

**2.** Lichtempfindliches Gemisch nach Anspruch 1, dadurch gekennzeichnet, daß das Molverhältnis von jeweils mit der Phenolverbindung umgesetzter Diazoverbindung zu umgesetztem organischen Säurehalogenid von 1:2 bis 19:1 reicht.

**3.** Lichtempfindliches Gemisch nach Anspruch 1 oder 2, dadurch gekennzeichnet, daß in der Phenolverbindung der Formel I

R -X-$R_b$
$R_a$ Wasserstoff und OH-Gruppen
x

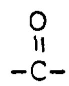

$R_b$ Aryl, insbesondere Phenyl,
in der Phenolverbindung der Formel II

$R_1$ Wasserstoff
$R_c$ OH-Gruppen
und in der Phenolverbindung der Formel III

$R_2$ Phenyl oder Alkyl mit 1 bis 20 C-Atomen
sowie in dem organischen Säurehalogenid der Formel IV

$R_3$ Alkyl mit vorzugsweise 1 bis 6 C-Atomen oder Phenyl
bedeutet.

**4.** Lichtempfindliches Gemisch nach einem oder mehreren der Ansprüche 1 bis 3, dadurch gekennzeichnet, daß das Bindemittel ein Novolak oder ein Polyvinylphenol ist.

**5.** Lichtempfindliches Gemisch nach einem oder mehreren der Ansprüche 1 bis 4, dadurch gekennzeichnet, daß das Gemisch ein Lösemittel bzw. ein Lösemittelgemisch enthält.

**6.** Lichtempfindliches Gemisch nach einem oder mehreren der Ansprüche 1 bis 5, dadurch gekennzeichnet, daß das Gemisch zusätzlich Farbstoffe, Verlaufmittel, Weichmacher, Haftvermittler, Entwicklungsbeschleuniger und/oder nicht-ionische Tenside enthält.

**7.** Lichtempfindliches Gemisch nach einem oder mehreren der Ansprüche 1 bis 6, dadurch gekennzeichnet, daß das Bindemittel in einer Konzentration von 15 bis 99 Gew.-%, bezogen auf die festen Bestandteile des lichtempfindlichen Gemisches, vorliegt.

**8.** Lichtempfindliches Gemisch nach einem oder mehreren der Ansprüche 1 bis 7, dadurch gekennzeichnet, daß die lichtempfindliche Verbindung in einer Konzentration von 1 bis 85 Gew.-%, bezogen auf die festen Bestandteile des lichtempfindlichen Gemisches, vorliegt.

**9.** Aufzeichnungsmaterial, im wesentlichen bestehend aus einem Träger und einer lichtempfindlichen Schicht, dadurch gekennzeichnet, daß die lichtempfindliche Schicht dem lichtempfindlichen Gemisch nach einem oder mehreren der Ansprüche 1 bis 8 entspricht.

**10.** Aufzeichnungsmaterial nach Anspruch 9, dadurch gekennzeichnet, daß der Träger ein mit einer thermisch gezüchteten Siliciumdioxidschicht beschichteter Siliciumwafer ist.

**11.** Verfahren zur Herstellung einer Photoresistschablone unter Verwendung eines Aufzeichnungsmaterials nach den Ansprüchen 9 oder 10, dadurch gekennzeichnet, daß das lichtempfindliche Gemisch auf den Träger aufgebracht wird, das Aufzeichnungsmaterial einer Vortrocknung bei 80 bis 105 °C unterworfen wird, bildmäßig belichtet und anschließend entwickelt und sowie ggf. einer Wärmebehandlung unterworfen wird.

**Claims**

**1.** Light-sensitive mixture, containing a binder, which is insoluble in aqueous systems and soluble or at least swellable in aqueous-alkaline and organic solvents, and also a light-sensitive compound, characterised in that the light-sensitive compound is a condensation product of a phenolic compound of the formula I

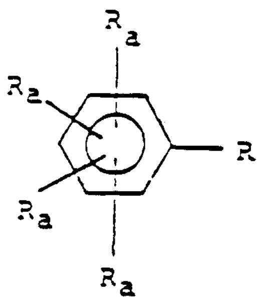

(I)

in which

R  is hydrogen, $-X-R_b$ or

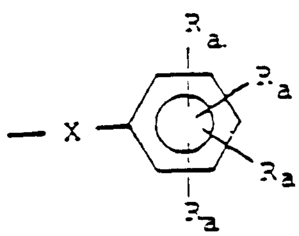

$R_a$  is hydrogen, an OH group, halogen or a lower alkyl group, at least two and at most six $R_a$ groups being OH groups,

X  is a C-C bond, -O-, -S-,

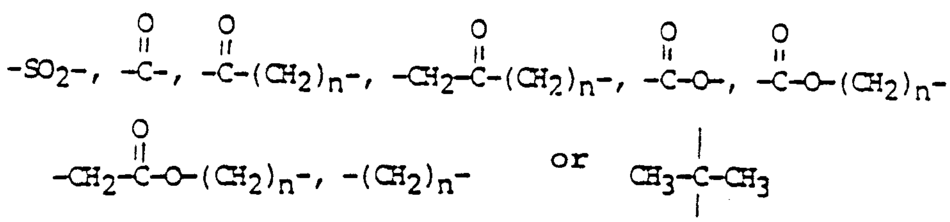

n  is 1 or 2 and

$R_b$  is hydrogen or a substituted or unsubstituted alkyl or aryl group,

or of the formula II

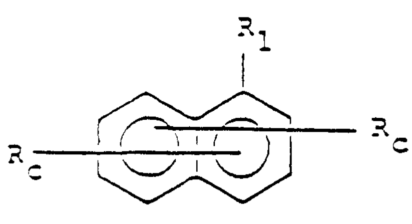

(II)

in which

$R_1$  is hydrogen or

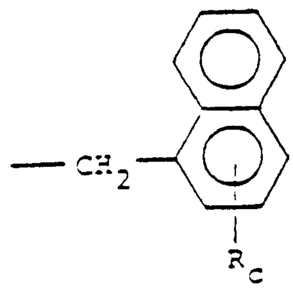

and

$R_c$ is hydrogen or an OH group, at least two $R_c$ groups being OH groups,

or of the formula III

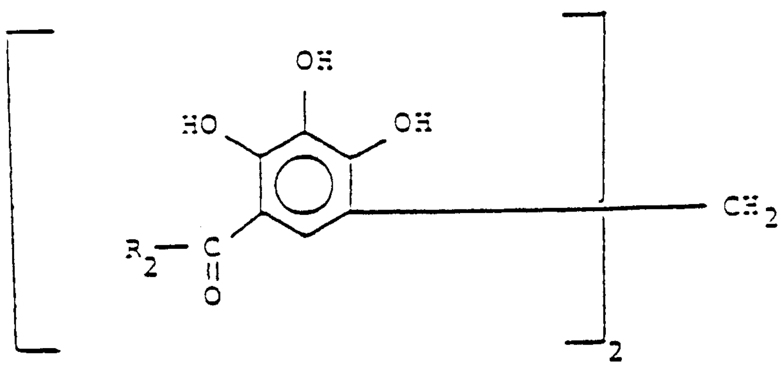 (III)

in which

$R_2$ is hydrogen or a substituted or unsubstituted alkyl or aryl group,

with a mixture of a 1,2-naphthoquinone-diazide-5-sulphonic acid chloride (diazo compound) and an organic acid halide of the formula IV

$W\text{-}R_3$ (IV)

in which

W is

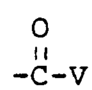

or $-SO_2$-V, V being a halogen, and

$R_3$ is a substituted or unsubstituted alkyl or aryl group.

**2.** Light-sensitive mixture according to Claim 1, characterised in that the molar ratio of diazo compound reacted with the phenolic compound to the reacted organic acid halide ranges in each case from 1:2 to 19:1.

**3.** Light-sensitive mixture according to Claim 1 or 2, characterised in that

R is $-X\text{-}R_b$,

$R_a$ is hydrogen and OH groups,

X is

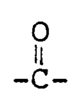

and

$R_b$ is aryl, especially phenyl,
in the phenolic compound of the formula I,
$R_1$ is hydrogen and
$R_c$ represents OH groups
in the phenolic compound of the formula II, and
$R_2$ is phenyl or alkyl having 1 to 20 carbon atoms
in the phenolic compound of the formula III and, furthermore,
$R_3$ is alkyl having preferably 1 to 6 carbon atoms or phenyl
in the organic acid halide of the formula IV.

**4.** Light-sensitive mixture according to one or more of Claims 1 to 3, characterised in that the binder is a novolak or a polyvinylphenol.

**5.** Light-sensitive mixture according to one or more of Claims 1 to 4, characterised in that the mixture contains a solvent or solvent mixture.

**6.** Light-sensitive mixture according to one or more of Claims 1 to 5, characterised in that the mixture additionally contains dyes, flow agents, plasticisers, adhesion promoters, development accelerators and/or nonionic surfactants.

**7.** Light-sensitive mixture according to one or more of Claims 1 to 6, characterised in that the binder is present in a concentration from 15 to 99 % by weight, relative to the solid constituents of the light-sensitive mixture.

**8.** Light-sensitive mixture according to one or more of Claims 1 to 7, characterised in that the light-sensitive compound is present in a concentration from 1 to 85 % by weight, relative to the solid constituents of the light-sensitive mixture.

**9.** Recording material, essentially consisting of a support and a light-sensitive layer, characterised in that the light-sensitive layer corresponds to the light-sensitive mixture according to one or more of Claims 1 to 8.

**10.** Recording material according to Claim 9, characterised in that the support is a silicon wafer coated with a thermally grown silica layer.

**11.** Process for producing a photoresist stencil, using a recording material according to Claim 9 or 10, characterised in that the light-sensitive mixture is applied to the support, the recording material is subjected to pre-drying at 80 to 105 °C, imagewise exposed and then developed and also, if desired, subjected to a heat treatment.

## Revendications

**1.** Composition photosensible contenant un liant insoluble dans des sytèmes aqueux, soluble ou au moins apte à gonfler dans des solvants organiques et aqueux-alcalins, ainsi qu'un composé photosensible, caractérisée en ce que le composé photosensible est un produit de condensation obtenu à partir d'un composé de type phénol de formule I

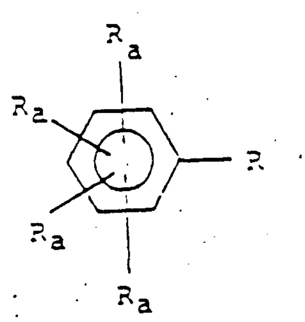

(I)

dans laquelle

R représente un atome d'hydrogène, $-X-R_b$ ou

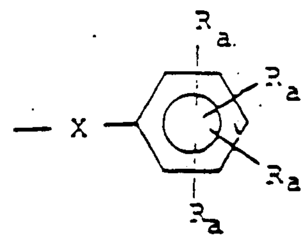

$R_a$ représente un atome d'hydrogène ou d'halogène, le groupe OH ou un groupe alkyle inférieur, au moins deux et au maximum six groupes $R_a$ étant des groupes OH,

X représente une liaison C-C-, -O-, -S-, $-SO_2-$,

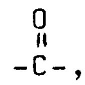

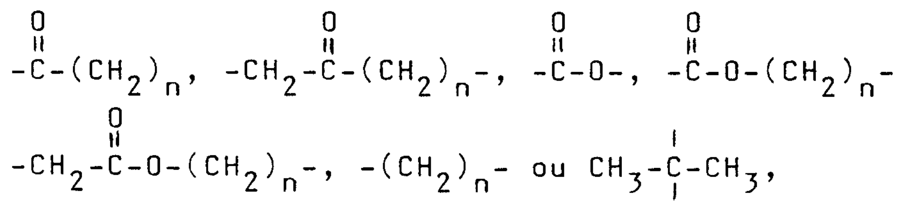

n est 1 ou 2 et

$R_b$ représente un atome d'hydrogène ou un groupe alkyle ou aryle éventuellement substitué;

ou de formule II

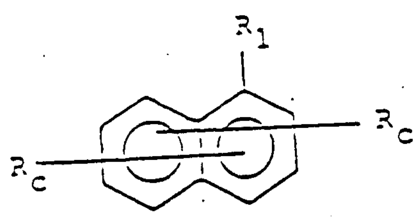

(II)

dans laquelle

$R_1$ représente un atome d'hydrogène ou

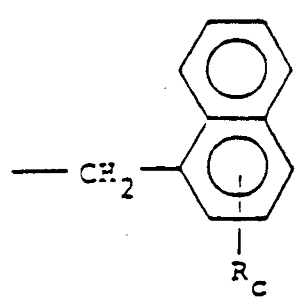

et

$R_c$ représente un atome d'hydrogène ou le groupe OH, au moins deux groupes $R_c$ représentant

des groupes OH;

ou de formule III

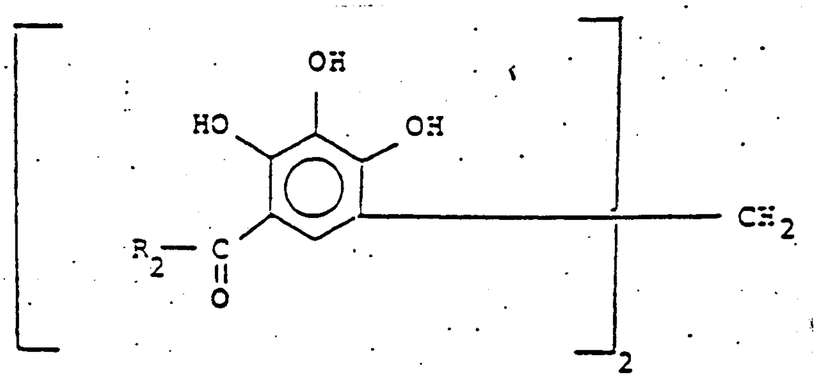

(III)

dans laquelle

$R_2$ représente un atome d'hydrogène ou un groupe alkyle ou aryle éventuellement substitué;

avec un mélange d'un chlorure de 1,2-naphtoquinonediazide-5-sulfonyle (composé diazo) et d'un halogénure d'acide organique de formule IV

$W\text{-}R_3$ (IV)

dans laquelle

W représente

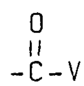

ou $-SO_2-V$, V représentant un halogène, et

$R_3$ représente un groupe alkyle ou aryle éventuellement substitué.

**2.** Composition photosensible selon la revendication 1, caractérisée en ce que le rapport molaire du composé diazo, mis en réaction avec le composé de type phénol, à l'halogénure d'acide organique mis en réaction, va de 1:2 à 19:1.

**3.** Composition photosensible selon la revendication 1 ou 2, caractérisée en ce que, dans le composé de type phénol de formule I

R représente $-X-R_b$,

$R_a$ représente un atome d'hydrogène ou le groupe OH,

X représente

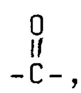

$R_b$ représente un groupe aryle, en particulier phényle;

dans le composé de type phénol de formule II

$R_1$ représente un atome d'hydrogène,

$R_c$ représente le groupe OH;

et dans le composé de type phénol de formule III

$R_2$ représente le groupe phényle ou un groupe alkyle ayant de 1 à 20 atomes de carbone;

et dans l'halogénure d'acide organique de formule IV

$R_3$ représente un groupe alkyle ayant de préférence de 1 à 6 atomes de carbone, ou le groupe phényle.

**4.** Composition photosensible selon une ou plusieurs des revendications 1 à 3, caractérisée en ce que le liant est une Novolaque ou un polyvinylphénol.

**5.** Composition photosensible selon une ou plusieurs des revendications 1 à 4, caractérisée en ce que la composition contient un solvant ou un mélange de solvants.

**6.** Composition photosensible selon une ou plusieurs des revendications 1 à 5, caractérisée en ce que le mélange contient en outre des colorants, agents d'étalement, plastifiants, agents favorisant l'adhérence, accélérateurs de développement et/ou surfactifs non ioniques.

**7.** Composition photosensible selon une ou plusieurs des revendications 1 à 6, caractérisée en ce que le liant est présent à une concentration de 15 à 99 % en poids, par rapport aux constituants solides de la composition photosensible.

**8.** Composition photosensible selon une ou plusieurs des revendications 1 à 7, caractérisée en ce que le composé photosensible est présent à une concentration de 1 à 85 % en poids, par rapport aux constituants solides de la composition photosensible.

**9.** Matériau de reprographie, essentiellement constitué d'un support et d'une couche photosensible, caractérisé en ce que la couche photosensible correspond à la composition photosensible selon une ou plusieurs des revendications 1 à 8.

**10.** Matériau de reprographie selon la revendication 9, caractérisé en ce que le support est une plaquette de silicium revêtue d'une couche de dioxyde de silicium produite thermiquement.

**11.** Procédé pour la préparation d'un masque de photoresist avec utilisation d'un matériau de reprographie selon la revendication 9 ou 10, caractérisé en ce que la composition photosensible est appliquée sur le support, le matériau de reproduction est soumis à un pré-séchage à 80-105 °C, exposé selon l'image et ensuite développé et éventuellement soumis à un traitement thermique.